# EUROPÄISCHE PATENTSCHRIFT

(11) **EP 3 447 850 B1**
(45) Veröffentlichungstag und Bekanntmachung des Hinweises auf die Patenterteilung: **03.02.2021**
(21) Anmeldenummer: 18190400.4
(22) Anmeldetag: 23.08.2018
(51) Int. Cl.: H01R 13/518, H01R 13/6587, H01R 12/72, H05K 1/11, H05K 1/02, H01R 12/70

(54) **VERBINDERSYSTEM, VERBINDERELEMENT UND VERFAHREN ZUR ASSEMBLIERUNG DES VERBINDERELEMENTS**
CONNECTOR SYSTEM, CONNECTOR ELEMENT AND METHOD FOR ASSEMBLY OF THE CONNECTOR ELEMENT
SYSTÈME DE RACCORD, ÉLÉMENT DE RACCORD ET PROCÉDÉ D'ASSEMBLAGE DE L'ÉLÉMENT DE RACCORD

(30) Priorität: 25.08.2017 DE 102017008065; 25.08.2017 DE 102017008087
(43) Veröffentlichungstag der Anmeldung: 27.02.2019
(73) Patentinhaber: Yamaichi Electronics Deutschland GmbH, 85609 Aschheim-Dornach (DE)
(72) Erfinder: Quiter, Michael, 57482 Wenden (DE); Serrano, Jaime Fernández, 80796 München (DE); Michel, Dirk, 85778 Haimhausen (DE)
(74) Vertreter: Müller-Boré & Partner Patentanwälte PartG mbB

(56) Entgegenhaltungen:
- US-A1- 2009 163 047

## Beschreibung

Die Erfindung betrifft ein kartenseitiges Verbinderelement für ein Verbindersystem zum Verbinden einer PCB-Karte mit einem Zentralrechner eines Kraftfahrzeugs. Ferner betrifft die Erfindung ein Verfahren zum Assemblieren des kartenseitigen Verbinderelements.

Moderne Kraftfahrzeuge werden mit einem Zentralrechner ausgestattet, der diverse Automotive Anwendungen ausführen bzw. steuern kann. Dazu kann der Zentralrechner des Kraftfahrzeugs wie bei einem Mainboard eines PCs oder Notebooks mit einer PCB (Printed Circuit Board) Karte bzw. einer Chipkarte verbunden werden, die für die jeweilige Anwendung spezifisch ist. Es ist daher erforderlich, ein für den Automotive Bereich geeignetes Verbindersystem zwischen einer PCB-Karte und dem Zentralrechner eines Kraftfahrzeugs bereitzustellen.

Im Stand der Technik existieren Netzwerkstecker bzw. Netzwerkverbinder aus dem Bereich der Telekommunikation, die jedoch nicht für den Automotive Bereich konzipiert bzw. geeignet sind. Weiterhin existieren hochpolige Verbinder, die eine Vielzahl von einzelnen Blechen zur Schirmung der Kontaktelemente aufweisen. Solche Verbinder sind jedoch nicht massentauglich und bereits aus diesem Grund nicht für den Automotive Bereich geeignet.

Die Druckschrift US 2009/163047 A1 beschreibt zum Beispiel einen herkömmlichen Steckverbinder, der über eine zweidimensionale Anordnung von Einpressstiften und leitfähigen elastischen Oberflächenkontaktelementen verfügt. Innerhalb des Steckverbinders befindet sich ein Satz Signalleiter. Jeder Leiter ist mit einem entsprechenden der Einpressstifte oder Oberflächenkontaktelementen verbunden. Wenn der Steckverbinder an einer Leiterplatte angebracht ist, ragen die Einpressstifte in die entsprechenden Durchkontaktierungen der Leiterplatte hinein und greifen in diese ein. Wenn die Einpressstifte in die Durchgangslöcher eingeführt werden, berühren die Einpressstifte die Oberfläche der Leiterplatte und werden zwischen dem Verbinder und der Leiterplatte zusammengedrückt, so dass jedes Oberflächenkontaktelement eine elektrische Verbindung zwischen einem Block auf der Leiterplatte und einem entsprechenden Leiter in dem Verbinder herstellt. Die Rückhaltekraft der Einpressstifte hält die Oberflächenkontaktelemente in ihrem komprimierten Zustand.

Es ist eine Aufgabe der vorliegenden Erfindung, ein kartenseitiges Verbinderelement für ein Verbindersystem zum Verbinden einer PCB-Karte mit einem Zentralrechner eines Kraftfahrzeugs bereitzustellen, welches den Anforderungen im Automotive Bereich, insbesondere hinsichtlich Stabilität, genügt und welches in einfacher und kostengünstiger Weise herstellbar ist. Darüber hinaus ist es eine Aufgabe der vorliegenden Erfindung, ein Verfahren für die Herstellung bzw. Assemblierung eines solchen kartenseitigen Verbinderelements anzugeben. Diese Aufgaben werden durch die Gegenstände der nebengeordneten Ansprüche gelöst. Vorteilhafte Ausführungsformen sind Gegenstand der Unteransprüche.

Ein erster unabhängiger Aspekt zur Lösung der Aufgabe betrifft ein kartenseitiges Verbinderelement nach Anspruch 1.

Unter einem "rechnerseitigen Verbinderelement" wird ein Verbinderelement verstanden, welches ausgelegt ist, um unmittelbar an einen Zentralrechner angeschlossen zu werden. Entsprechend wird unter einem "kartenseitigen Verbinderelement" ein Verbinderelement verstanden, welches ausgelegt ist, um unmittelbar an eine PCB-Karte angeschlossen zu werden. Allgemein deutet die Zusatzbezeichnung "rechnerseitig" bei verschiedenen Elementen an, dass diese Elemente zu dem rechnerseitigen Verbinderelement gehören. Entsprechend deutet die Zusatzbezeichnung "kartenseitig" bei verschiedenen Elementen an, dass diese Elemente zu dem kartenseitigen Verbinderelement gehören.

Eine PCB-Karte kann z.B. eine PCMCIA Express 3.0 bzw. 4.0 Karte sein. Es versteht sich, dass mit "PCB-Karte" auch sämtliche andere Chipkarten umfasst sind, welche insbesondere für die Verwendung im Automotive Bereich geeignet sind.

Unter einer kartenseitigen Kontaktelementeinheit wird insbesondere ein einstückig ausgebildetes Bauteil oder eine einstückig ausgebildete Komponente des kartenseitigen Verbinderelements verstanden. Das kartenseitige Verbinderelement kann nur eine Kontaktelementeinheit, oder aber auch zwei, drei, vier, fünf, usw., Kontaktelementeinheiten aufweisen. Vorzugsweise weist das kartenseitige Verbinderelement acht Kontaktelementeinheiten auf. Jede der zumindest einen Kontaktelementeinheit weist eine Mehrzahl, insbesondere zwei, drei, vier, fünf, usw., kartenseitige Kontaktelemente auf. Vorzugsweise weist jede kartenseitige Kontaktelementeinheit ein bis fünfzehn, insbesondere sieben, kartenseitige Kontaktelemente auf. Als Kontaktelement werden allgemein elektrische Leiter verstanden, mit denen elektrische Signale übertragen werden können. Die Kontaktelemente sind vorzugsweise aus CuSn6 oder alternativen Kupferlegierungen ausgebildet bzw. gefertigt. Als Isoliermaterial können z.B. Polyamide (PA) und/oder flüssigkristalline Polymere (LCP) verwendet werden.

Ein Hybridbauteil im Sinne der vorliegenden Beschreibung ist ein Bauteil, welches aus verschiedenen Werkstoffen hergestellt wird. Dabei kann z.B. ein erster Werkstoff (hier insbesondere ein Werkstoff für die Kontaktelemente) mit einem zweiten Werkstoff (hier insbesondere ein Isolier- bzw. Kunststoffmaterial) umspritzt werden. Somit ist ein Hybridbauteil im Sinne der vorliegenden Beschreibung insbesondere ein Metall-Kunststoff-Bauteil, welches eine Mehrzahl von Kontaktelementen (Metall) aufweist, die mit Hilfe eines Kunststoffspritzprozesses bereichsweise (d.h. bis auf erste und zweite Endabschnitte der Kontaktelemente) mit einem Isoliermaterial (Kunststoff) ummantelt wurden. Insbesondere können die Kontaktelemente zunächst auf eine gewünschte bzw. vorgegebene Form gestanzt und anschließend in einem Kunststoffspritzprozess bereichsweise mit Kunststoff ummantelt werden. Der Begriff "bereichsweise" bedeutet hier, dass die Kontaktelemente nicht vollständig mit Isoliermaterial bzw. Kunststoff umgeben bzw. ummantelt werden. Vielmehr wird jeweils nur ein mittlerer Abschnitt der Kontaktelemente mit Isoliermaterial umgeben, während erste und zweite Endabschnitte der Kontaktelemente frei bleiben.

Die Herstellung eines Hybridbauteils kann insbesondere folgende Schritte umfassen:
a) Stanzen der Kontaktelemente;
b) Oberflächenbeschichten der Kontaktelemente, z.B. mit Gold;
c) Einlegen der gestanzten Kontaktelemente in ein Umspritzwerkzeug und Umspritzen der gestanzten Kontaktelemente mit einem Isoliermaterial, insbesondere Kunststoff.

Die kartenseitige(n) Kontaktelementeinheit(en) kann/können somit in einer sogenannten Metall-Kunststoff Hybridbauweise hergestellt werden.

Im Rahmen der vorliegenden Erfindung hat sich herausgestellt, dass das erfindungsgemäße kartenseitige Verbinderelement den Anforderungen im Automotive Bereich, insbesondere hinsichtlich Stabilität, genügt. Des Weiteren kann es, insbesondere dank der Kontaktelementeinheiten, in einfacher und kostengünstiger Weise hergestellt und assembliert werden. Folglich ist das erfindungsgemäße Verbindersystem bzw. das erfindungsgemäße kartenseitige Verbinderelement auch massentauglich.

In einer bevorzugten Ausführungsform sind mittlere Abschnitte der kartenseitigen Kontaktelemente der zumindest einen kartenseitigen Kontaktelementeinheit von dem Isolier- bzw. Kunststoffmaterial des Hybridbauteils umgeben. Ferner ragen erste und zweite Endabschnitte der kartenseitigen Kontaktelemente der zumindest einen kartenseitigen Kontaktelementeinheit aus dem Isoliermaterial des Hybridbauteils heraus. Mit anderen Worten werden bzw. sind die Kontaktelemente der kartenseitigen Kontaktelementeinheiten zumindest bereichsweise in ein Isoliermaterial bzw. in das Innere einer Isolierplatte eingearbeitet. Die Kontaktelemente der kartenseitigen Kontaktelementeinheiten sind somit zumindest bereichsweise in dem Isoliermaterial bzw. innerhalb der Isolierplatte der jeweiligen Kontaktelementeinheit angeordnet.

In einer weiteren bevorzugten Ausführungsform weisen die Kontaktelemente, und insbesondere die mittleren Abschnitte der Kontaktelemente, der zumindest einen kartenseitigen Kontaktelementeinheit jeweils eine im Wesentlichen rechtwinklige Kante auf. Insbesondere sind die Kontaktelemente, und insbesondere die mittleren Abschnitte der Kontaktelemente, der zumindest einen kartenseitigen Kontaktelementeinheit innerhalb jeder der zumindest einen kartenseitigen Kontaktelementeinheit derart angeordnet, dass diese Kanten im Wesentlichen auf einer Geraden liegen. Vorzugsweise ist diese Gerade etwa 45° zu einer ersten Montagerichtung und etwa 45° zu einer zweiten Montagerichtung ausgerichtet (die Begriffe erste und zweite Montagerichtung werden nachfolgend definiert). Mit anderen Worten weisen die Kontaktelemente der zumindest einen kartenseitigen Kontaktelementeinheit, bzw. deren mittleren Abschnitte, jeweils einen Knick auf, der in etwa rechtwinklig ausgebildet ist. Auf diese Weise wird eine besonders kompakte und stabile Bauweise des Verbindersystems bzw. des kartenseitigen Verbinderelements erreicht.

In einer weiteren bevorzugten Ausführungsform ist das rechnerseitige Verbinderelement ausgelegt, um entlang der ersten Montagerichtung mit dem Zentralrechner verbunden, insbesondere zusammengesteckt, zu werden. Das kartenseitige Verbinderelement ist ausgelegt, um entlang der zweiten Montagerichtung mit der PCB-Karte verbunden, insbesondere zusammengesteckt, zu werden. Ferner sind das rechnerseitige Verbinderelement und das kartenseitige Verbinderelement entlang der ersten Montagerichtung verbindbar bzw. zusammensteckbar. Vorzugsweise unterscheidet sich die erste Montagerichtung von der zweiten Montagerichtung. Insbesondere ist die erste Montagerichtung im Wesentlichen senkrecht zur zweiten Montagerichtung.

In einer weiteren bevorzugten Ausführungsform sind erste Endabschnitte der kartenseitigen Kontaktelemente der zumindest einen kartenseitigen Kontaktelementeinheit im Wesentlichen parallel zur ersten Montagerichtung ausgerichtet. Ferner sind zweite Endabschnitte der kartenseitigen Kontaktelemente der zumindest einen kartenseitigen Kontaktelementeinheit im Wesentlichen parallel zur zweiten Montagerichtung ausgerichtet. Insbesondere werden bzw. sind die Kontaktelemente derart gestanzt, dass die oben beschriebene Konfiguration bzw. Ausrichtung der kartenseitigen Kontaktelemente der zumindest einen kartenseitigen Kontaktelementeinheit erreicht wird.

In einer weiteren bevorzugten Ausführungsform sind im montierten Zustand diejenigen Kontaktelemente, welche einer kartenseitigen Kontaktelementeinheit angehören, in einer Ebene angeordnet. Vorzugsweise ist diese Ebene parallel zur ersten Montagerichtung und senkrecht zur zweiten Montagerichtung ausgerichtet.

Unter einem montierten Zustand wird im Sinne der vorliegenden Beschreibung ein Zustand verstanden, in dem das Verbindersystem bzw. das rechnerseitige und das kartenseitige Verbinderelement bestimmungsgemäß verwendet wird bzw. werden und/oder bestimmungsgemäß montiert, zusammengesetzt oder zusammengesteckt ist bzw. sind. Insbesondere wird unter einem montierten Zustand verstanden, dass das rechnerseitige und kartenseitige Verbinderelement miteinander verbunden sind. Ein montierter Zustand kann daher auch als zusammengebauter Zustand, zusammengesetzter Zustand, zusammengesteckter Zustand und/oder als Betriebszustand bezeichnet werden. Mit anderen Worten bezeichnet der montierte Zustand eines Verbinderelements bzw. Verbindersystems eine bestimmungsgemäße Anordnung oder Einbauposition der einzelnen Elemente des Verbinderelements bzw. Verbindersystems.

In einer weiteren bevorzugten Ausführungsform weist das kartenseitige Verbinderelement ein kartenseitiges Gehäuse auf, welches aus Zinkdruckguss ausgebildet bzw. gefertigt ist. Vorzugsweise ist das Zinkdruckguss-Material ein EZDA3 (Zinc Die Casting Alloy) und insbesondere eine in der Norm EN 12844 beschriebene ZP0410-, ZP0400- und/oder ZPO430-Legierung. Es versteht sich, dass aber auch alternative Zinkdruckguss-Materialien verwendet werden können.

Das kartenseitige Verbinderelement weist ein erstes kartenseitiges Gehäuseelement mit einem ersten Fixierelement und ein zweites kartenseitiges Gehäuseelement mit einem zweiten Fixierelement auf. Mit anderen Worten umfasst das kartenseitige Gehäuse ein erstes und zweites Gehäuseelement und ist somit zweistückig ausgebildet. Das erste und zweite kartenseitige Gehäuseelement sind derart ausgebildet, dass das erste kartenseitige Gehäuseelement an das zweite kartenseitige Gehäuseelement mit Hilfe des ersten Fixierelements, des zweiten Fixierelements und eines dritten Fixierelements miteinander verbunden bzw. fixiert werden können. Die Fixierung kann lösbar oder auch unlösbar sein. Erfindungsgemäß wird zum Verbinden bzw. Fixieren des ersten Gehäuseelements mit dem zweiten Gehäuseelement das dritte Fixierelement mit dem ersten Fixierelement des ersten Gehäuseelements und mit dem zweiten Fixierelement des zweiten Gehäuseelements in Eingriff gebracht. Beispielsweise können die Fixierelemente miteinander verrastet werden. Die Fixierelemente können daher auch als Eingriffs- bzw. Verrastelemente bezeichnet werden. Das Dritte Fixierelement ist insbesondere eine Klammer, welche mit dem ersten und zweiten Fixierelement in Eingriff gebracht werden kann.

Mit Hilfe des dritten Fixierelements werden die beiden kartenseitigen Gehäuseelemente zusammengehalten, um einen anschließenden Lötvorgang zu ermöglichen bzw. zu vereinfachen. Mittels Verlöten werden schließlich das erste und zweite kartenseitige Gehäuseelement fest bzw. unlösbar miteinander verbunden.

In einer weiteren bevorzugten Ausführungsform ist die zumindest eine kartenseitige Kontaktelementeinheit im montierten Zustand zwischen dem ersten kartenseitigen Gehäuseelement und dem zweiten kartenseitigen Gehäuseelement angeordnet. Insbesondere umschließen die beiden kartenseitigen Gehäuseelemente sämtliche kartenseitigen Kontaktelementeinheiten. Somit können die Kontaktelementeinheiten bzw. die Kontaktelemente vor äußeren Einflüssen geschützt werden. Zudem sorgen die Gehäuse aus Zinkdruckguss vorteilhafterweise für eine gute Abschirmung und damit für eine hohe Signalqualität.

In einer weiteren bevorzugten Ausführungsform weist das kartenseitige Verbinderelement ferner einen kartenseitigen Isolierkörper mit einer Mehrzahl von kartenseitigen Isolierhohlräumen auf. im montierten Zustand sind erste Endabschnitte der kartenseitigen Kontaktelemente zumindest bereichsweise in den kartenseitigen Isolierhohlräumen angeordnet. Insbesondere ist im montierten Zustand jedes kartenseitige Kontaktelement in jeweils einem zugehörigen kartenseitigen Isolierhohlraum angeordnet. Ferner sind die kartenseitigen Isolierhohlräume vorzugsweise ausgelegt, um rechnerseitige Kontaktelemente des rechnerseitigen Verbinderelements zumindest bereichsweise aufzunehmen.

In einer weiteren bevorzugten Ausführungsform grenzt der kartenseitige Isolierkörper im montierten Zustand unmittelbar an die zumindest eine kartenseitige Kontaktelementeinheit an.

In einer weiteren bevorzugten Ausführungsform weist das kartenseitige Verbinderelement zumindest zwei, beispielsweise zwei, drei, vier, usw., und insbesondere sieben, plattenförmige kartenseitige Kontaktelementeinheiten auf. Dabei sind die zumindest zwei plattenförmigen kartenseitigen Kontaktelementeinheiten im montierten Zustand im Wesentlichen parallel zueinander angeordnet. Insbesondere sind die plattenförmigen kartenseitigen Kontaktelementeinheiten derart angeordnet, dass Normalenvektoren der plattenförmigen kartenseitigen Kontaktelementeinheiten in eine Richtung zeigen, welche senkrecht zur ersten und zweiten Montagerichtung ist. Unter einem Normalenvektor wird hier ein Vektor verstanden, der senkrecht auf einer Grundfläche der kartenseitigen Kontaktelementeinheiten steht.

In einer weiteren bevorzugten Ausführungsform sind die kartenseitigen Kontaktelemente der zumindest einen kartenseitigen Kontaktelementeinheit als Single-End Kontaktelemente ausgebildet. Mit anderen Worten sind die kartenseitigen Kontaktelemente der zumindest einen kartenseitigen Kontaktelementeinheit zur Übertragung von w-speed Datensignalen ausgebildet bzw. ausgelegt. Ferner weist das kartenseitige Verbinderelement eine Mehrzahl von kartenseitigen Differential-Pair Kontaktelementen und/oder eine Mehrzahl von Power-Kontaktelementen auf.

Im Vergleich zu Single-End Kontaktelementen, welche jeweils nur einen Signalleiter aufweisen, werden Differential-Pair Kontaktelemente für eine symmetrische oder differentielle Signalübertragung, d.h. zum Übertragen von Differenzsignalen, verwendet. Eine symmetrische Signalübertragung ist ein Verfahren, um Signale auch bei längeren Übertragungswegen möglichst tolerant gegenüber Störeinstrahlungen übermitteln zu können. Die Übertragung erfolgt dabei statt mit nur einem einzigen Signalleiter mit einem Paar gleichartiger Signalleiter, also mit Hilfe eines Differential-Pair Kontaktelementpaares. Dabei wird auf der einen Leitung das eigentliche Signal und auf der anderen Leitung ein dem Empfänger bekanntes Referenzsignal, insbesondere das um 180° phasenverdrehte Signal, übertragen. Die Beeinflussung des Nutzsignals durch Einkopplungen auf dem Übertragungsweg ist auf beiden Leitern nahezu gleichartig, wenn sie die gleiche Quellimpedanz, gleiche Leitungsimpedanz und gleiche Lastimpedanz aufweisen. Bei Differenzbildung der beiden Leiter-Potenziale hebt sich die Störung dann nahezu auf. Die Power-Kontaktelemente dienen zur Energieversorgung.

Im Rahmen der vorliegenden Erfindung hat sich herausgestellt, dass es für Automotive Anwendungen hinsichtlich der erforderlichen Übertragungsqualität und der Frequenzbereiche vorteilhaft ist, zusätzlich zu den Single-End Kontaktelementen der zumindest einen kartenseitigen Kontaktelementeinheit eine symmetrische Signalübertragung mit Hilfe von Differential-Pair Kontaktelementen bereitzustellen. Diese Differential-Pair Kontaktelemente und auch die Power-Kontaktelemente werden jedoch, insbesondere aus Kostengründen, vorzugsweise nicht in Form von vorgefertigten Kontaktelementeinheiten bereitgestellt.

Die Differential-Pair Kontaktelemente und die Power-Kontaktelemente können z.B. wie folgt gefertigt werden:
- Spritzen eines Differential-Pair- bzw. Power-Isolierkörpers;
- Stanzen der Differential-Pair- bzw. Power-Kontaktelemente;
- Oberflächenbeschichten der Differential-Pair- bzw. Power-Kontaktelemente, z.B. mit Gold; und
- Anordnen bzw. Montieren der Differential-Pair- bzw. Power-Kontaktelemente in dem Differential-Pair- bzw. Power-Isolierkörper.

Das rechnerseitige Verbinderelement kann ferner eine Vielzahl von rechnerseitigen hohlförmigen Isolierkörpern aufweisen, welche im montierten Zustand innerhalb der rechnerseitigen Kontakthohlräume angeordnet sind. Vorzugsweise sind die rechnerseitigen Isolierkörper aus den Materialien PA9T, PA10T oder LCP ausgebildet bzw. gefertigt. Die Anzahl der rechnerseitigen Isolierkörper entspricht vorzugsweise der Anzahl an rechnerseitigen Kontakthohlräumen. Die rechnerseitigen Isolierkörper sind vorzugsweise rechteckförmig ausgebildet.

Zusätzlich kann das rechnerseitige Verbinderelement eine Vielzahl von rechnerseitigen Kontaktelementen, insbesondere Kontaktstifte, aufweisen. Vorzugsweise sind die rechnerseitigen Kontaktelemente aus CuSn6 oder alternativen Kupferlegierungen ausgebildet bzw. gefertigt. Als Kontaktelement werden allgemein elektrische Leiter verstanden, mit denen elektrische Signale übertragen werden können. Die rechnerseitigen Kontaktelemente können im montierten Zustand zumindest bereichsweise innerhalb von rechnerseitigen Isolierhohlräumen der rechnerseitigen Isolierkörper, und damit auch innerhalb der rechnerseitigen Kontakthohlräume, angeordnet sein. Mit anderen Worten können die rechnerseitigen Isolierkörper die rechnerseitigen Kontaktelemente zumindest bereichsweise umgeben. "Zumindest bereichsweise" bedeutet in diesem Zusammenhang, dass jeweils zumindest ein Abschnitt eines rechnerseitigen Kontaktelements innerhalb eines rechnerseitigen Isolierhohlraums eines rechnerseitigen Isolierkörpers angeordnet ist bzw. dass ein rechnerseitiger Isolierkörper zumindest einen Abschnitt eines rechnerseitigen Kontaktelements umgibt. Insbesondere sind die rechnerseitigen Kontaktelemente im montierten Zustand zumindest bereichsweise innerhalb von rechnerseitigen Isolierhohlräumen der rechnerseitigen Isolierkörper angeordnet, so dass sie gegenüber dem rechnerseitigen Gehäuse elektrisch isoliert sind. Die rechnerseitigen Kontaktelemente können das rechnerseitige Gehäuse im Wesentlichen vollständig durchdringen.

Abgesehen von der isolierenden Wirkung dienen die rechnerseitigen Isolierkörper auch dazu, die rechnerseitigen Kontaktelemente in den rechnerseitigen Kontakthohlräumen zu halten bzw. zu befestigen. Die Isolierkörper haben somit neben ihrer Isolierfunktion auch eine Stabilitätsfunktion, d.h. eine Halte- bzw. Befestigungsfunktion. An den Stellen bzw. Abschnitten der Kontaktelemente, die nicht von einem Isolierkörper umgeben sind, kann Luft als Isolator dienen.

Ein Steckende der rechnerseitigen Kontaktelemente kann aus dem rechnerseitigen Gehäuse herausragen und zum Kontaktieren des Zentralrechners ausgebildet sein.

Ein weiterer unabhängiger Aspekt zur Lösung der Aufgabe betrifft ein Verfahren zum Assemblieren eines kartenseitigen Verbinderelements nach Anspruch 14. Der Begriff "Assemblieren" umfasst insbesondere ein Montieren und/oder Zusammenbauen verschiedener Komponenten des Verbinderelements.

Das Anordnen der zumindest einen Kontaktelementeinheit in dem ersten kartenseitigen Gehäuseelement erfolgt insbesondere derart, dass die ersten Endabschnitte der Kontaktelemente in das erste Gehäuseelement eintauchen.

Vor dem Anordnen des zweiten kartenseitigen Gehäuseelements an dem ersten kartenseitigen Gehäuseelement erfolgt das Anordnen bzw. die Montage der zumindest einen Kontaktelementeinheit in dem ersten kartenseitigen Gehäuseelement. Entsprechend können in diesem Schritt auch die weiteren kartenseitigen Kontaktelemente des kartenseitigen Verbinderelements, d.h. die kartenseitigen Differential-Pair Kontaktelemente und die kartenseitigen Power-Kontaktelemente in dem ersten kartenseitigen Gehäuseelement angeordnet bzw. montiert werden. Nachdem alle Kontaktelementeinheiten bzw. Kontaktelemente angeordnet bzw. montiert wurden, wird das zweite Gehäuseelement von unten über die Kontaktelementeinheiten bzw. Kontaktelemente gesteckt. Anschließend werden das erste und zweite Gehäuseelement mittels des (dritten) Fixierelements bzw. mittels der Fixierelemente fixiert und somit zueinander in Position gehalten.

Das auf diese Weise assemblierte (aber noch nicht verlötete) kartenseitige Verbinderelement kann an einen Kunden geliefert werden und ein Verlöten, insbesondere der Kontaktelemente mit der PCB-Karte, erfolgt vorzugsweise erst beim Kunden. Das erfindungsgemäße Verfahren kann aber optional auch vor der Auslieferung zum Kunden noch den folgenden Schritt umfassen:
- Anordnen der Endabschnitte der Kontaktelemente an vorgesehenen Lötstellen der PCB-Karte und Verlöten der Kontaktelemente mit der PCB-Karte.

Insbesondere kann durch das Verlöten, vorzugsweise mittels Reflow-Technik, auch das erste kartenseitige Gehäuseelement direkt mit dem zweiten kartenseitigen Gehäuseelement fest bzw. unlösbar verbunden werden. Eine Verlötung zwischen dem ersten und zweiten Gehäuseelement ist jedoch nicht zwingend notwendig, da bereits durch die Verlötung mit der PCB-Karte beide Gehäuseelemente indirekt miteinander fixiert werden. Mit anderen Worten kann also die Stabilität bzw. Fixierung der beiden Gehäuseelemente lediglich indirekt über die PCB-Karte erreicht werden. Nach dem Verlöten wird die Funktion der Fixierelemente, und insbesondere das dritte Fixierelement, nicht mehr benötigt. Das dritte Fixierelement kann also entweder im Eingriff mit dem ersten und zweiten Fixierelement des kartenseitigen Verbinderelements verbleiben oder alternativ auch wieder entfernt werden.

Für die oben genannten weiteren unabhängigen Aspekte und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen der jeweils anderen unabhängigen Aspekte.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.

### Kurze Beschreibung der Zeichnungen

- Figur 1: zeigt in einer perspektivischen Explosionsansicht eine schematische Skizze eines Verbindersystems gemäß einer bevorzugten Ausführungsform der vorliegenden Erfindung;
- Figur 2A: zeigt in einer ersten perspektivischen Ansicht (Vorderansicht) eine schematische Skizze eines rechnerseitigen Gehäuses des Verbindersystems aus Figur 1;
- Figur 2B: zeigt in einer zweiten perspektivischen Ansicht (Rückansicht) eine schematische Skizze eines rechnerseitigen Gehäuses des Verbindersystems aus Figur 1;
- Figur 3: zeigt in der perspektivischen Ansicht aus Figur 2A (Vorderansicht) eine schematische Skizze des rechnerseitigen Verbinderelements des Verbindersystems aus Figur 1 ohne das rechnerseitige Gehäuse.
- Figur 4: zeigt in einer perspektivischen Ansicht eine schematische Skizze des kartenseitigen Gehäuses des kartenseitigen Verbinderelements von Figur 1, wobei sich das erste und zweite kartenseitige Gehäuseelement in einem montierten bzw. zusammengesteckten Zustand befinden;
- Figur 5: zeigt in einer weiteren perspektivischen Ansicht eine schematische Skizze des kartenseitigen Gehäuses des kartenseitigen Verbinderelements von Figur 1, wobei sich das erste und zweite kartenseitige Gehäuseelement in einem demontierten Zustand befinden;
- Figur 6a: zeigt in einer perspektivischen Ansicht eine schematische Skizze des kartenseitigen Verbinderelements von Figur 1, wobei sich das erste und zweite kartenseitige Gehäuseelement in einem demontierten Zustand befinden;
- Figur 6b: zeigt in einer Schnittansicht (Seitenansicht) eine kartenseitige Kontaktelementeinheit gemäß einer bevorzugten Ausführungsform;
- Figur 7a: zeigt in einer perspektivischen Schnittansicht eine schematische Skizze von einem Teil des kartenseitigen Verbinderelements;
- Figur 7b: zeigt in einer weiteren perspektivischen Schnittansicht eine schematische Skizze von einem Teil des kartenseitigen Verbinderelements;
- Figur 8a: zeigt in einer Draufsicht eine schematische Skizze des kartenseitigen Verbinderelements von Figur 1;
- Figur 8b: zeigt eine schematische Skizze des kartenseitigen Verbinderelements der Figur 1 von unten;

### Detaillierte Beschreibung der Zeichnungen

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen. Die Zusatzbezeichnung "rechnerseitig", wie sie in der vorliegenden Beschreibung für verschiedene Elemente verwendet wird, soll andeuten, dass diese Elemente zu dem rechnerseitigen Verbinderelement, d.h. einem Verbinderelement, welches unmittelbar mit dem Zentralrechner verbunden werden kann, gehören. Entsprechend deutet die Zusatzbezeichnung "kartenseitig" bei verschiedenen Elementen an, dass diese Elemente zu dem kartenseitigen Verbinderelement, d.h. einem Verbinderelement, welches unmittelbar mit einer PCB-Karte verbunden werden kann, gehören.

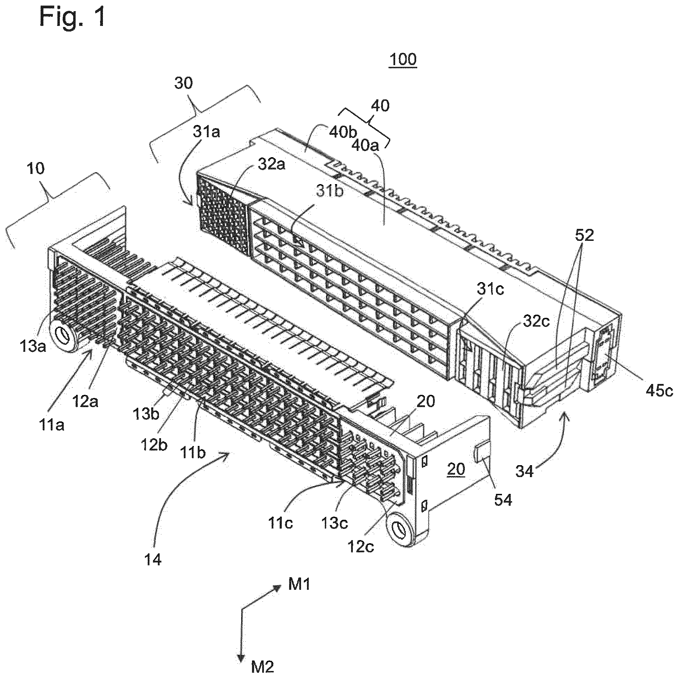

Die **Figur 1** zeigt in einer perspektivischen Explosionsansicht eine schematische Skizze des erfindungsgemäßen Verbindersystems 100 gemäß einer bevorzugten Ausführungsform. In dieser Explosionsansicht ist ein rechnerseitiges Verbinderelement 10 und ein kartenseitiges Verbinderelement 30 des Verbindersystems 100 separat, d.h. in einem nicht zusammengesteckten bzw. montierten Zustand gezeigt. Im vollständig montierten Zustand sind das rechnerseitige Verbinderelement 10 und das kartenseitige Verbinderelement 30 miteinander verbunden, d.h. entlang einer mit einem Pfeil gekennzeichneten ersten Montagerichtung M1 zusammengesteckt.

Das rechnerseitige Verbinderelement 10 ist ausgelegt, um mit einer rechnerseitigen Steckseite 14 voran an einen Zentralrechner eines Kraftfahrzeugs (nicht gezeigt) angeschlossen bzw. angesteckt zu werden. Im gezeigten Ausführungsbeispiel ist die Steckseite 14 im montierten Zustand diejenige Seite des rechnerseitigen Verbinderelements 10, welche dem kartenseitigen Verbinderelement 30 abgewandt ist. Eine Normale auf die rechnerseitige Steckseite 14 ist etwa entgegengesetzt parallel zur ersten Montagerichtung M1 angeordnet.

Das rechnerseitige Verbinderelement 10 weist eine Mehrzahl von Kontaktelementen 13a, 13b und 13c auf, die mit komplementären Kontaktelementen des Zentralrechners verbunden werden können. Im Ausführungsbeispiel der Figur 1 weist das Verbindersystem 100 bzw. das rechnerseitige Verbinderelement 10 (und analog dazu das kartenseitige Verbinderelement 30) drei unterschiedliche Kontaktbereiche auf, nämlich einen Single-End-Kontaktbereich mit einer Mehrzahl von Single-End-Kontaktelementen 13a, einen Differential-Pair-Kontaktbereich mit einer Mehrzahl von Differential-Pair-Kontaktelementen 13b und einen Power-Kontaktbereich mit einer Mehrzahl von Power-Kontaktelementen 13c. Während die Single-End-Kontaktelemente 13a Signale bzw. Informationen jeweils nur über einen einzelnen elektrischen Leiter übertragen, so werden bei den Differential-Pair-Kontaktelementen 13b jeweils zwei elektrische Leiter verwendet, um ein Differenzsignal dieser beiden Leiter zu übertragen. Einige der Power-Kontaktelemente 13c sind im gezeigten Ausführungsbeispiel ähnlich wie die Differential-Pair-Kontaktelemente 13b jeweils paarweise ausgeführt, während andere als 3er-Kontakt ausgeführt sind. Die Power-Kontaktelemente 13c dienen zur Energie- bzw. Leistungsüberträgung.

Das rechnerseitige Verbinderelement 10 weist ein rechnerseitiges Gehäuse 20 mit einer Mehrzahl von rechnerseitigen Kontakthohlräumen 11a, 11b, und 11c auf, nämlich einem rechnerseitigen Single-Pair-Kontakthohlraum 11a, einer Mehrzahl (hier genau 48) rechnerseitige Differential-Pair-Kontakthohlräume 11b und einem rechnerseitigen Power-Kontakthohlraum 11c. Sämtliche Kontakthohlräume 11a-11c sind durch das rechnerseitige Gehäuse 20 hindurch verlaufend ausgebildet und durchdringen somit das rechnerseitige Gehäuse 20 vollständig. Die Kontakthohlräume 11a-11c weisen (in erster Montagerichtung M1, siehe unten) einen etwa konstanten Querschnitt auf, welcher z.B. etwa rechteckig ausgebildet ist. Ferner weist das rechnerseitige Verbinderelement 10 eine Mehrzahl von rechnerseitigen Isolierkörpern 12a, 12b und 12c auf, welche jeweils zumindest einen Isolierraum ausbilden und umschließen, der durch das rechnerseitige Gehäuse 20 hindurch verlaufend ausgebildet ist.

Die Isolierkörper 12a, 12b und 12c sind innerhalb der rechnerseitigen Kontakthohlräume 11a-11c angeordnet. Im gezeigten Ausführungsbeispiel weist das rechnerseitige Verbinderelement 10 einen rechnerseitigen Single-Pair-Isolierkörper 12a auf, eine Mehrzahl (hier genau 48) rechnerseitige Differential-Pair-Isolierkörper 12b und einen rechnerseitigen Power-Isolierkörper 12c.

Die rechnerseitigen Kontaktelemente 13a-13c sind im montierten Zustand zumindest bereichsweise innerhalb von rechnerseitigen Isolierhohlräumen der jeweils zugehörigen rechnerseitigen Isolierkörper 12a-12c angeordnet. So sind die Single-End-Kontaktelemente 13a im Single-End-Kontakthohlraum 11a und innerhalb von Isolierhohlräumen des Single-End-Isolierkörpers 12a angeordnet. Die Differential-Pair-Kontaktelemente 13b sind jeweils in zugehörigen Differential-Pair-Kontakthohlräumen 11b und innerhalb von zugehörigen Isolierhohlräumen der Differential-Pair-Isolierkörper 12b angeordnet. Die Power-Kontaktelemente 13c sind in dem Power-Kontakthohlraum 11c und jeweils innerhalb von zugehörigen Isolierhohlräumen des Power-Isolierkörpers 12c angeordnet.

Das kartenseitige Verbinderelement 30 ist ausgelegt, um mit einer PCB-Karte entlang einer zweiten Montagerichtung M2 verbunden zu werden. Dazu weist das kartenseitige Verbinderelement 30 auf seiner Unterseite, der kartenseitigen Steckseite 34, rechnerseitigen Kontaktelementen 13a-13c entsprechende kartenseitige Kontaktelemente (in Figur 1 nicht gezeigt) auf. Dabei sind die kartenseitigen Kontaktelemente etwa rechtwinklig ausgebildet mit einem ersten Abschnitt, der sich etwa parallel zur ersten Montagerichtung M1 erstreckt, und einem zweiten Abschnitt, der sich etwa parallel zur zweiten Montagerichtung M2 erstreckt. Der zweite Abschnitt der kartenseitigen Kontaktelemente kann hierbei aus der kartenseitigen Steckseite 34 herausragen zum (elektrischen und/oder physikalischen) kontaktieren der PCB-Karte.

Wie in der Figur 1 gezeigt, ist die zweite Montagerichtung M2 im Wesentlichen senkrecht zur ersten Montagerichtung M1 ausgerichtet. Das kartenseitige Verbinderelement 30 ist dazu ausgebildet und vorgesehen, mit seiner kartenseitigen Steckseite 34 voran in Richtung der zweiten Montagerichtung M2 an der (nicht gezeigten) PCB-Karte befestigt, z.B. verlötet, zu werden. Die kartenseitige Steckseite 34 ist im montierten Zustand in einer Ebene angeordnet, die etwa senkrecht zu der Ebene angeordnet ist, in der die rechnerseitige Steckseite 14 angeordnet ist.

Das kartenseitige Verbinderelement 30 weist ein kartenseitiges Gehäuse 40 mit einer Mehrzahl von kartenseitigen Kontakthohlräumen 31a-31c auf. Dabei weist das kartenseitige Gehäuse 40 zwei kartenseitige Gehäuseelemente 40a und 40b auf, welche miteinander verbunden bzw. zusammengesteckt werden können.

Das kartenseitige Gehäuse 40 weist eine Mehrzahl von kartenseitigen Isolierkörpern 32a-32c auf, welche im montierten Zustand innerhalb der kartenseitigen Kontakthohlräume 31a-31c angeordnet sind. Die kartenseitigen Isolierkörper 32a-32c wiederum weisen kartenseitige Isolierhohlräume auf, die ausgelegt sind, um im montierten Zustand zugehörige rechnerseitige Kontaktelemente 13a-13c zumindest bereichsweise aufzunehmen. Sowohl die kartenseitigen Kontakthohlräume 31a-31c, die kartenseitigen Isolierkörpern 32a-32c, als auch die kartenseitigen Kontaktelemente sind winklig ausgebildet. Die kartenseitigen Kontakthohlräume 31a-31c usw. weisen dabei einen ersten Abschnitt auf, welcher etwa parallel zur ersten Montagerichtung M1 ausgebildet ist, und einen zweiten Abschnitt, welcher etwa parallel zur zweiten Montagerichtung M2 ausgebildet ist.

Im gezeigten Ausführungsbeispiel weist das kartenseitige Verbinderelement 30 einen kartenseitigen Single-Pair-Isolierkörper 32a, eine Mehrzahl (hier genau 48) kartenseitige Differential-Pair-Isolierkörper 32b und einen kartenseitigen Power-Isolierkörper 32c auf. Die kartenseitigen Kontaktelemente (nicht in Figur 1 gezeigt) sind im montierten Zustand zumindest bereichsweise innerhalb von kartenseitigen Isolierhohlräumen der jeweils zugehörigen kartenseitigen Isolierkörper 32a-32c angeordnet. So sind Single-End-Kontaktelemente im Single-End-Kontakthohlraum 31a und innerhalb von Isolierhohlräumen des Single-End-Isolierkörpers 32a angeordnet. Differential-Pair-Kontaktelemente bzw. Differential-Pair-Kontaktelementpaare sind jeweils in zugehörigen Differential-Pair-Kontakthohlräumen 31b und innerhalb von zugehörigen Isolierhohlräumen der Differential-Pair-Isolierkörper 32b angeordnet. Power-Kontaktelemente sind in dem Power-Kontakthohlraum 31c und innerhalb von zugehörigen Isolierhohlräumen des Power-Isolierkörpers 32c angeordnet.

Im montierten Zustand, in dem das rechnerseitige Verbinderelement 10 mit dem kartenseitigen Verbinderelement 30 verbunden und/oder zusammengesteckt ist, kontaktieren sich die rechnerseitigen Kontaktelemente 13a-13c und die kartenseitigen Kontaktelemente in den kartenseitigen Kontakthohlräumen 31a-31c und in den Isolierhohlräumen der kartenseitigen Isolierkörper 32a-32c.

Das rechnerseitige Gehäuse 20 kann ferner eine Mehrzahl von Stabilisierungselementen aufweisen, während das kartenseitige Gehäuse 40 eine entsprechende Anzahl von komplementären Stabilisierungselementen aufweisen kann. Beim Zusammenstecken des rechnerseitigen Verbinderelements 10 und des kartenseitigen Verbinderelements 30 greifen die Stabilisierungselemente ineinander ein und stabilisieren die Steckverbindung im montierten Zustand. Zusätzlich können die Stabilisierungselemente auch als Steckhilfe dienen.

Das kartenseitige Gehäuse 40 weist zudem zumindest ein Führungselement 52, z.B. einen Vorsprung, auf, welcher beim Zusammenstecken des rechnerseitigen Verbinderelements 10 und des kartenseitigen Verbinderelements 30 in ein komplementäres Führungselement 54 des rechnerseitigen Gehäuses 10 eingreift. Dabei kann eines der Führungselemente 52 länglich ausgebildet sein, etwa parallel zur ersten Montagerichtung M1 ausgerichtet sein und/oder sich in Richtung zum zugeordneten Verbinderelement 10 bzw. 30 hin verjüngend ausgebildet sein. Dies erleichtert das Ausrichten des rechnerseitigen und kartenseitigen Verbinderelements 10 und 30 beim Zusammenstecken und somit auch die Montage des Verbindersystems 100. Des Weiteren ist in der Figur 1 ein Fixierelement bzw. eine Klammer 45c gezeigt, mit der das erste Gehäuseelement 40a an das zweite Gehäuseelement 40b fixiert ist.

Das rechnerseitige Gehäuse 20 und das kartenseitige Gehäuse 40 sind vorzugsweise jeweils aus Zinkdruckguss ausgebildet und gefertigt, in welchem die Kontakthohlräume 12a-12c bzw. 32a-32c vorgesehen sind. Dadurch kann bewirkt werden, dass die rechnerseitigen Kontaktelemente 13a-13c und die kartenseitigen Kontaktelemente nicht nur mechanisch geschützt sind, sondern auch elektrisch geschirmt sind, um elektromagnetische Störeinflüsse zu reduzieren und/oder zu vermeiden.

Ferner kann das kartenseitige Gehäuse 40 ein Federelement aufweisen, welches das kartenseitige Gehäuse 40 elektrisch kontaktiert und welches ausgelegt ist, um im montierten Zustand auch das rechnerseitige Gehäuse 20 elektrisch zu kontaktieren. Somit besteht ein elektrischer Kurzschluss zwischen den beiden Gehäusen 20 und 40, was die Schirmung der Kontaktelemente und damit die Signalqualität weiter verbessert.

Das rechnerseitige Verbinderelement 10 und das kartenseitige Verbinderelement 30 können z.B. eine Länge (etwa senkrecht zu den beiden Montagerichtungen M1 und M2) von etwa 85 mm, eine Tiefe (etwa parallel zur ersten Montagerichtung M1) von etwa 15 mm und eine Höhe (etwa parallel zur zweiten Montagerichtung M2) von etwa 12 mm aufweisen. Diese Abmessungen sind lediglich beispielhaft für den Automotive-Bereich und können je nach Anwendung auch andere für den Automotive Bereich geeignete Dimensionen einnehmen.

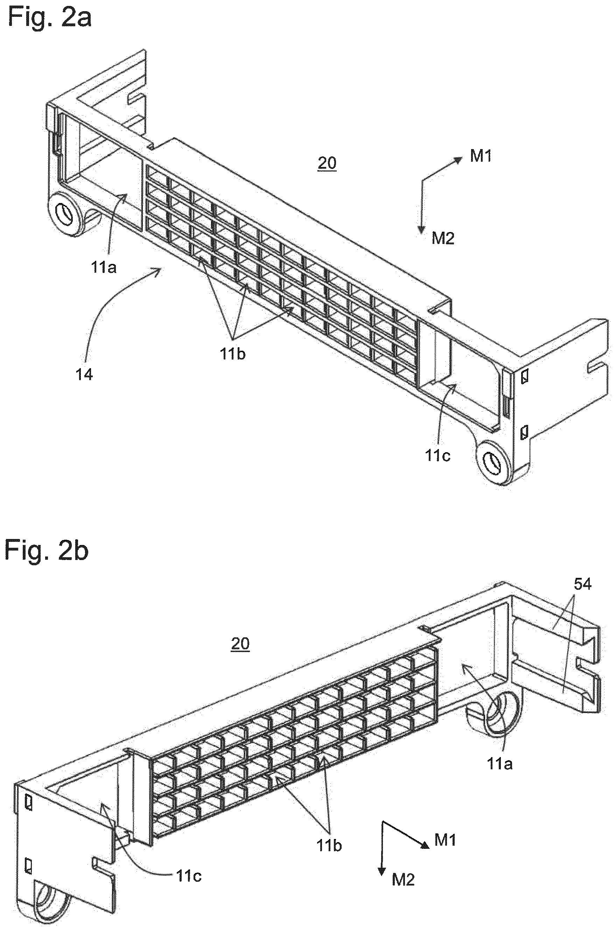

Die **Figur 2A** zeigt in einer ersten perspektivischen Ansicht (schräge Vorderansicht) eine schematische Skizze des rechnerseitigen Gehäuses 20 des in der Figur 1 gezeigten Verbindersystems 100, während die **Figur 2B** das rechnerseitige Gehäuse 20 in einer zweiten perspektivischen Ansicht (schräge Rückansicht) zeigt. In den Figuren 2A und 2B sind nochmals die Kontakthohlräume 11a-11c gezeigt, welche das rechnerseitige Gehäuse 20 vollständig durchdringen und einen etwa rechteckigen Querschnitt aufweisen.

Wie in den Figuren 2A und 2B gezeigt, weist insbesondere jeder einzelne der Kontakthohlräume 11b einen etwa rechteckigen Querschnitt auf zum drehfesten Aufnehmen der Differential-Pair-Isolierkörper 12b. Beim Zusammenstecken des rechnerseitigen Verbinderelements 10 und des kartenseitigen Verbinderelements 30, d.h. im montierten Zustand, werden von den rechnerseitigen Kontakthohlräume 11a-11c und den kartenseitigen Kontakthohlräume 31a-31c zusammen durchgängige Kanäle und/oder Hohlräume für die Kontaktelemente ausgebildet.

Im montierten Zustand können die beiden Gehäuse 20 und 40 aneinander gekoppelt und/oder elektrisch kontaktiert sein, was die Schirmung verbessert.

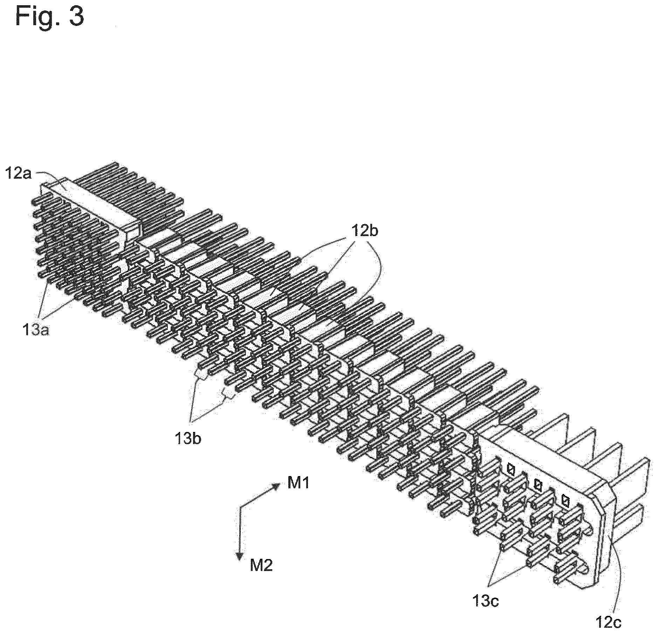

Die **Figur 3** zeigt eine schematische Skizze des rechnerseitigen Verbinderelements 10 aus Figur 1. Im Vergleich zur Figur 1 wurde in der Figur 3 z.B. das rechnerseitige Gehäuse 20 ausgeblendet, so dass die rechnerseitigen Isolierkörper 12a-12c und die rechnerseitigen Kontaktelemente 13a-13c besser gezeigt sind. Insbesondere ist in Figur 3 gezeigt, dass die hohlförmigen Isolierkörper 12a-12c die Kontaktelemente 13a-13c zumindest bereichsweise umgeben. Mit anderen Worten sind die Kontaktelemente 13a-13c zumindest bereichsweise innerhalb von Hohlräumen der Isolierkörper 12a-12c angeordnet.

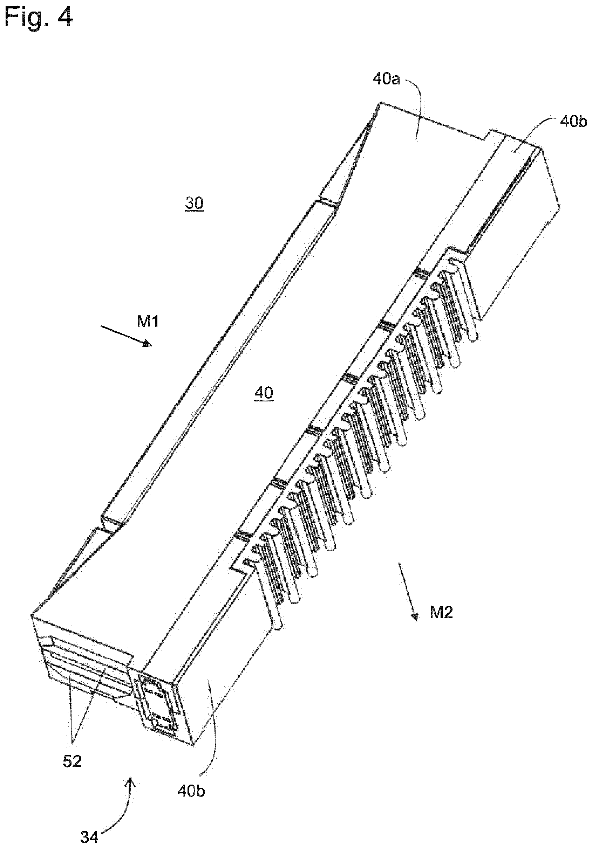

Die **Figur 4** zeigt in einer weiteren perspektivischen Ansicht (schräge Rückansicht) das kartenseitige Verbinderelement 30 der Figur 1. Wie bereits erwähnt, ist das kartenseitige Gehäuse 40 des kartenseitigen Verbinderelements 30 zweiteilig ausgebildet und weist ein erstes kartenseitiges Gehäuseelement 40a und ein zweites kartenseitiges Gehäuseelement 40b auf. Das erste und zweite kartenseitige Gehäuseelement befinden sich in der Figur 4 in einem montierten bzw. zusammengesteckten Zustand.

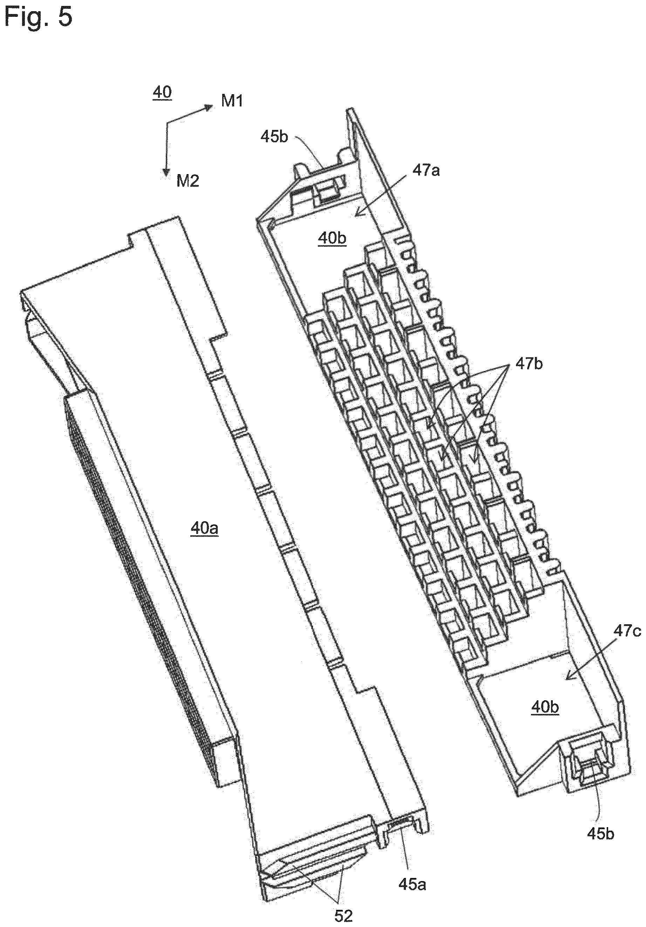

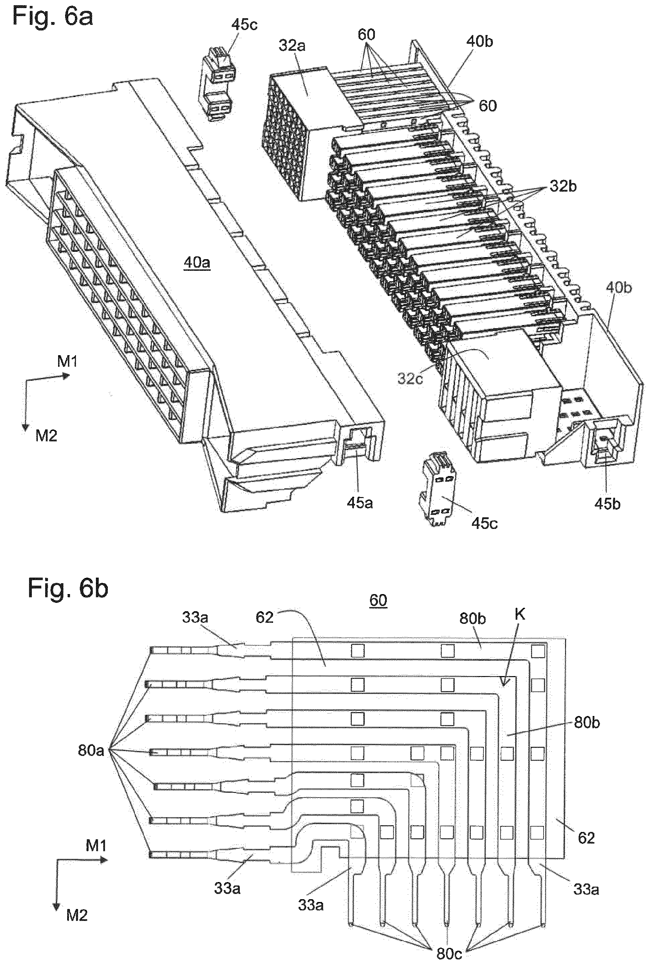

Die **Figur 5** zeigt in einer weiteren perspektivischen Ansicht eine schematische Skizze des kartenseitigen Gehäuses 40, wobei sich das erste kartenseitige Gehäuseelement 40a und das zweite kartenseitige Gehäuseelement 40b in einem demontierten Zustand befinden. In diesem demontierten Zustand sind Hohlräume zur Aufnahme von Kontaktelementen zu sehen, nämlich ein kartenseitiger Single-End-Kontakthohlraum 47a, ein kartenseitiger Differential-Pair-Kontakthohlraum 47b und ein kartenseitiger Power-Kontakthohlraum 47c. In dem kartenseitigen Single-End-Kontakthohlraum 47a befinden sich im montierten Zustand ein oder mehrere kartenseitige Kontaktelementeinheiten 60 (in Figur 5 nicht gezeigt). Das erste kartenseitige Gehäuseelement 40a weist zwei erste Fixierelemente 45a auf (in der Figur 5 ist nur eines davon ersichtlich) und das zweite kartenseitige Gehäuseelement 40b weist zwei zweite Fixierelemente 45b auf. Mit Hilfe von dritten Fixierelementen 45c (siehe z.B. Figur 1 und Figur 6a) kann das erste Gehäuseelement 40a an das zweite Gehäuseelement 40b fixiert werden.

Die **Figur 6a** zeigt in einer perspektivischen Ansicht eine schematische Skizze des kartenseitigen Verbinderelements 30, wobei sich das erste und zweite kartenseitige Gehäuseelement 40a, 40b in einem demontierten Zustand befinden. In dem kartenseitigen Single-Pair Kontakthohlraum 47a (siehe Figur 5) sind eine Mehrzahl von kartenseitigen Kontaktelementeinheiten 60 angeordnet. Des Weiteren ist ein kartenseitiges Single-Pair Isolierelement bzw. ein kartenseitiger Single-Pair Isolierkörper 32a unmittelbar benachbart zu den kartenseitigen Kontaktelementeinheiten 60 angeordnet. In dem kartenseitigen Differential-Pair Kontakthohlraum 47b (siehe Figur 5) sind eine Mehrzahl von kartenseitigen Differential-Pair Isolierelementen 32b angeordnet, in denen sich kartenseitige Differential-Pair Kontaktelemente (in der Figur 6a nicht zu sehen) befinden. In dem kartenseitigen Power Kontakthohlraum 47c (siehe Figur 5) ist ein kartenseitiges Power Isolierelement 32c angeordnet, in dem sich im montierten Zustand kartenseitige Power Kontaktelemente (in der Figur 6a ausgeblendet) befinden. Des Weiteren sind in der Figur 6a auch die zwei dritten Fixierelemente 45c gezeigt, welche im zusammengesteckten Zustand in die ersten Fixierelemente 45a und die zweiten Fixierelemente 45b eingreifen, um das erste und zweite Gehäuseelement 40a, 40b miteinander zu verbinden und zusammenzuhalten.

In der **Figur 6b** ist in einer Schnittansicht (Seitenansicht) eine kartenseitige Kontaktelementeinheit 60 gemäß einer bevorzugten Ausführungsform dargestellt. Die Kontaktelementeinheit 60 ist als Hybridbauteil mit einer Mehrzahl (hier sieben) von bereichsweise mit einem Isoliermaterial 62 umgebenen bzw. ummantelten kartenseitigen Kontaktelementen 33a ausgebildet.

Die kartenseitigen Kontaktelemente 33a sind gewinkelt ausgebildet. Mittlere Abschnitte 80b der kartenseitigen Kontaktelemente 33a sind von dem Isoliermaterial 62 des Hybridbauteils umgeben, während erste Endabschnitte 80a und zweite Endabschnitte 80b der kartenseitigen Kontaktelemente 33a aus dem Isoliermaterial 62 des Hybridbauteils herausragen. Die Kontaktelemente 33a sind also zumindest bereichsweise in dem Isoliermaterial bzw. einer Isolierplatte 62 eingearbeitet. Insbesondere sind die Kontaktelemente 33a zumindest bereichsweise innerhalb des Isoliermaterials bzw. im Inneren der Isolierplatte 62 angeordnet.

Die mittleren Abschnitte 80b der Kontaktelemente 33a weisen jeweils eine im Wesentlichen rechtwinklige Kante K auf. Ferner sind die mittleren Abschnitte 80b der Kontaktelemente 33a derart angeordnet, dass die Kanten K im Wesentlichen auf einer Geraden liegen, welche in etwa 45° zur ersten Montagerichtung und etwa 45° zur zweiten Montagerichtung ausgerichtet ist.

Die ersten Endabschnitte 80a der kartenseitigen Kontaktelemente 33a sind im montierten Zustand im Wesentlichen parallel zur ersten Montagerichtung M1 ausgerichtet. Die zweiten Endabschnitte 80c der kartenseitigen Kontaktelemente 33a sind im Wesentlichen parallel zur zweiten Montagerichtung M2 ausgerichtet. Wie in Figur 6b weiter erkennbar ist, sind sämtliche Kontaktelemente 33a der Kontaktelementeinheit 60 in einer Ebene angeordnet, welche parallel zur ersten Montagerichtung M1 und senkrecht zur zweiten Montagerichtung M2 ausgerichtet ist.

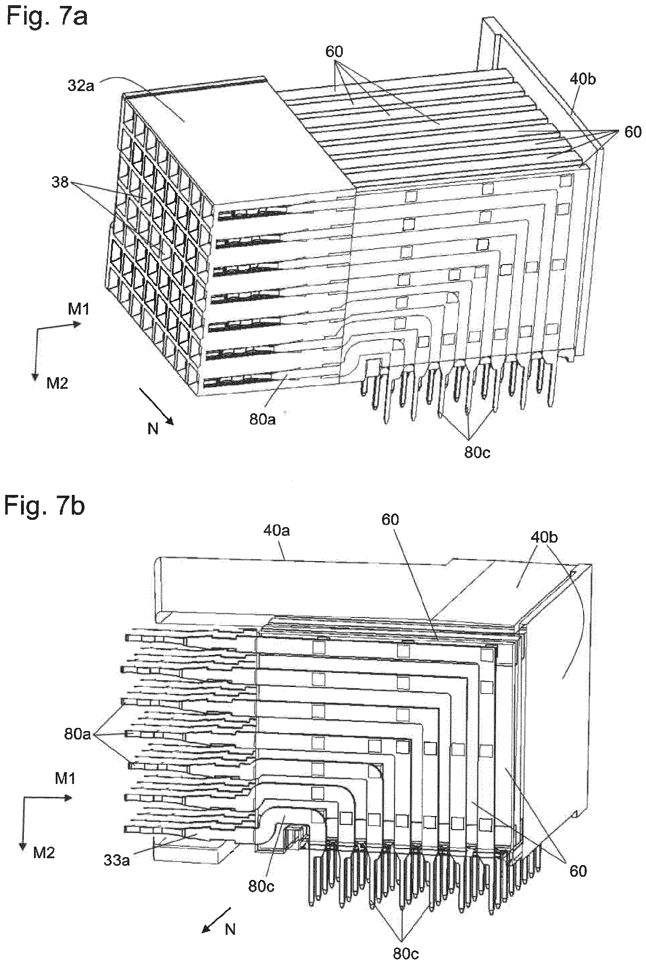

Im montierten Zustand sind die ersten Endabschnitte 80a der kartenseitigen Kontaktelemente 33a zumindest bereichsweise in kartenseitigen Single-Pair Isolierhohlräumen 38 (siehe Figur 7a) des kartenseitigen Single-Pair Isolierelements 32a (siehe Figur 6a) angeordnet. Die kartenseitigen Isolierhohlräume 38 des kartenseitigen Single-Pair Isolierelements 32a sind ferner dazu ausgelegt, um die rechnerseitigen Single-Pair Kontaktelemente 13a des rechnerseitigen Verbinderelements 10 (siehe die Figuren 1 und 3) zumindest bereichsweise aufzunehmen. Auf diese Weise können die rechnerseitigen und kartenseitigen Kontaktelemente miteinander kontaktieren.

Die **Figuren 7a und 7b** zeigen in unterschiedlichen perspektivischen Schnittansichten jeweils eine schematische Skizze von einem Teil des kartenseitigen Verbinderelements 30. Insbesondere sind hier Teile des ersten und zweiten Gehäuseelements 40a und 40b und eine Mehrzahl von kartenseitigen Kontaktelementeinheiten 60 zu erkennen. In der Figur 7a ist ferner das kartenseitige Single-End Isolierelement 32a mit einer Vielzahl von Isolierhohlräumen 38, in denen die ersten Endabschnitte 80a der kartenseitigen Kontaktelemente 33a angeordnet sind, gezeigt. In der Figur 7b ist das kartenseitige Single-End Isolierelement 32a ausgeblendet, so dass die ersten Endabschnitte 80a der kartenseitigen Kontaktelemente 33a besser zum Vorschein treten. Die zweiten Endabschnitte 80c der kartenseitigen Kontaktelemente 33a ragen aus dem zweiten Gehäuseelement 40b heraus, um mit einer PCB-Karte (nicht gezeigt) verbunden bzw. an die PCB-Karte angelötet zu werden.

Wie in den Figuren 7a und 7b zu erkennen ist, sind die kartenseitigen Kontaktelementeinheiten 60 plattenförmig ausgebildet. Im montierten Zustand sind die kartenseitigen Kontaktelementeinheiten 60 im Wesentlichen parallel zueinander angeordnet sind. Insbesondere sind die kartenseitigen Kontaktelementeinheiten 60 derart angeordnet, dass ein Normalenvektor N der kartenseitigen Kontaktelementeinheiten 60 im Wesentlichen senkrecht zur ersten Montagerichtung M1 und senkrecht zur zweiten Montagerichtung M2 steht.

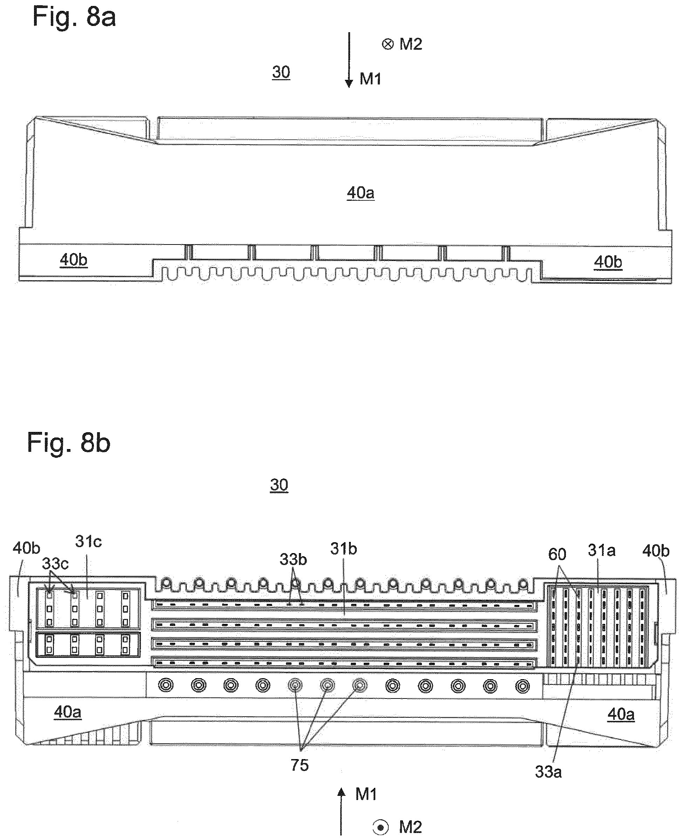

Die **Figur 8a** zeigt eine schematische Skizze des kartenseitigen Verbinderelements 30 in einer Draufsicht, während die **Figur 8b** eine schematische Skizze des kartenseitigen Verbinderelements 30 von unten zeigt. Auf der rechten Seite von Figur 8b befindet sich der Single-End Bereich des kartenseitigen Verbinderelements 30 mit dem kartenseitigen Single-End Kontakthohlraum 31a und den darin angeordneten kartenseitigen Kontaktelementeinheiten 60, welche ihrerseits die kartenseitigen Single-End Kontaktelemente 33a umfassen. In der Mitte von Figur 8b befindet sich der Differential-Pair Bereich des kartenseitigen Verbinderelements 30 mit dem kartenseitigen Differential-Pair Kontakthohlraum 31b und den darin angeordneten Differential-Pair Kontaktelementen 33b. Auf der rechten Seite von Figur 8b befindet sich der Power Bereich des kartenseitigen Verbinderelements 30 mit dem kartenseitigen Power Kontakthohlraum 31c und den darin angeordneten Power Kontaktelementen 33c. Des Weiteren sind in Figur 8b mehrere Lötpins 75 erkennbar, welche dazu dienen, das kartenseitige Verbinderelement 30 stabil mit der PCB-Karte zu verbinden.

### Bezugszeichenliste

- 10: rechnerseitiges Verbinderelement
- 11: rechnerseitige Kontakthohlräume
- 11a: rechnerseitiger Single-End Kontakthohlraum
- 11b: rechnerseitiger Differential-Pair Kontakthohlraum
- 11c: rechnerseitiger Power Kontakthohlraum
- 12: rechnerseitiger Isolierkörper / rechnerseitiges Isolierelement
- 12a: rechnerseitiger Single-End Isolierkörper
- 12b: rechnerseitiger Differential-Pair Isolierkörper
- 12c: rechnerseitiger Power Isolierkörper
- 13: rechnerseitige Kontaktelemente
- 13a: rechnerseitiges Single-End Kontaktelement
- 13b: rechnerseitiges Differential-Pair Kontaktelement bzw. Kontaktelementpaar
- 13c: rechnerseitiges Power Kontaktelement
- 14: rechnerseitige Steckseite
- 20: rechnerseitiges Gehäuse/Zinkdruckguss-Gehäuse
- 30: kartenseitiges Verbinderelement
- 31: kartenseitige Kontakthohlräume
- 31a: kartenseitiger Single-End Kontakthohlraum
- 31b: kartenseitiger Differential-Pair Kontakthohlraum
- 31c: kartenseitiger Power Kontakthohlraum
- 32: kartenseitiger Isolierkörper / kartenseitiges Isolierelement
- 32a: kartenseitiger Single-End Isolierkörper
- 32b: kartenseitiger Differential-Pair Isolierkörper
- 32c: kartenseitiger Power Isolierkörper
- 33: kartenseitige Kontaktelemente
- 33a: kartenseitiges Single-End Kontaktelement
- 33b: kartenseitiges Differential-Pair Kontaktelement bzw. Kontaktelementpaar
- 33c: kartenseitiges Power Kontaktelement
- 34: kartenseitige Steckseite
- 38: Isolierhohlraum
- 40: kartenseitiges Gehäuse / Zinkdruckguss-Gehäuse
- 40a: erstes kartenseitiges Gehäuseelement
- 40b: zweites kartenseitiges Gehäuseelement
- 45a: erstes Fixierelement / erstes Eingriffselement
- 45b: zweites Fixierelement / zweites Eingriffselement
- 45c: drittes Fixierelement / drittes Eingriffselement / Klammer
- 47a: kartenseitiger Single-End-Kontakthohlraum
- 47b: kartenseitiger Differential-Pair-Kontakthohlraum
- 47c: kartenseitiger Power-Kontakthohlraum
- 52: Führungselement
- 54: komplementäres Führungselement
- 60: Kontaktelementeinheit / Hybridbauteil
- 62: Isoliermaterial / Isolierplatte
- 75: Lötpins
- 80a: erster Endabschnitt
- 80b: mittlerer Abschnitt
- 80c: zweiter Endabschnitt
- 100: Verbindersystem
- M1: erste Montagerichtung
- M2: zweite Montagerichtung
- N: Normalenvektor

## Patentansprüche

1. Kartenseitiges Verbinderelement (30) für ein Verbindersystem (100) zum Verbinden einer PCB-Karte mit einem Zentralrechner eines Kraftfahrzeugs, aufweisend:
- zumindest eine kartenseitige Kontaktelementeinheit (60), wobei jede Kontaktelementeinheit (60) als Hybridbauteil mit einer Mehrzahl von bereichsweise mit einem Isoliermaterial (62) umgebenen kartenseitigen Kontaktelementen (33a) ausgebildet ist;
- ein erstes kartenseitiges Gehäuseelement (40a) mit einem ersten Fixierelement (45a);
- ein zweites kartenseitiges Gehäuseelement (40b) mit einem zweiten Fixierelement (45b); und
- ein drittes Fixierelement (45c); **dadurch gekennzeichnet, dass** das erste kartenseitige Gehäuseelement (40a) an das zweite kartenseitige Gehäuseelement (40b) mit Hilfe des ersten Fixierelements (45a), des zweiten Fixierelements (45b) und des dritten Fixierelements (45c), welches mit dem ersten Fixierelement (45a) und dem zweiten Fixierelement (45b) in Eingriff gebracht werden kann, fixierbar ist.

2. Verbindersystem (100) zum Verbinden einer PCB-Karte mit einem Zentralrechner eines Kraftfahrzeugs, aufweisend ein rechnerseitiges Verbinderelement (10) und ein kartenseitiges Verbinderelement (30) nach Anspruch 1.

3. Verbindersystem (100) nach Anspruch 2, wobei mittlere Abschnitte (80b) der kartenseitigen Kontaktelemente (33a) der zumindest einen kartenseitigen Kontaktelementeinheit (60) von dem Isoliermaterial (62) des Hybridbauteils umgeben sind und wobei erste und zweite Endabschnitte (80a, 80c) der kartenseitigen Kontaktelemente (33a) der zumindest einen kartenseitigen Kontaktelementeinheit (60) aus dem Isoliermaterial (62) des Hybridbauteils herausragen.

4. Verbindersystem (100) nach einem der Ansprüche 2 und 3, wobei die Kontaktelemente (33a) der zumindest einen kartenseitigen Kontaktelementeinheit (60) jeweils eine im Wesentlichen rechtwinklige Kante (K) aufweisen, und wobei die Kontaktelemente (33a) der zumindest einen kartenseitigen Kontaktelementeinheit (60) innerhalb jeder der zumindest einen kartenseitigen Kontaktelementeinheit (60) insbesondere derart angeordnet sind, dass die Kanten (K) im Wesentlichen auf einer Geraden liegen.

5. Verbindersystem (100) nach einem der Ansprüche 2 bis 4, wobei das rechnerseitige Verbinderelement (10) ausgelegt ist, um entlang einer ersten Montagerichtung (M1) mit dem Zentralrechner verbunden zu werden, wobei das kartenseitige Verbinderelement (30) ausgelegt ist, um entlang einer zweiten Montagerichtung (M2) mit der PCB-Karte verbunden zu werden, und wobei das rechnerseitige Verbinderelement (10) und das kartenseitige Verbinderelement (30) entlang der ersten Montagerichtung (M1) zusammensteckbar sind.

6. Verbindersystem (100) nach Anspruch 5, wobei erste Endabschnitte (80a) der kartenseitigen Kontaktelemente (33a) der zumindest einen kartenseitigen Kontaktelementeinheit (60) im Wesentlichen parallel zur ersten Montagerichtung (M1) ausgerichtet sind, und wobei zweite Endabschnitte (80c) der kartenseitigen Kontaktelemente (33a) der zumindest einen kartenseitigen Kontaktelementeinheit (60) im Wesentlichen parallel zur zweiten Montagerichtung (M2) ausgerichtet sind.

7. Verbindersystem (100) nach einem der Ansprüche 2 bis 6, wobei im montierten Zustand diejenigen Kontaktelemente (33a), welche einer kartenseitigen Kontaktelementeinheit (60) angehören, in einer Ebene angeordnet sind.

8. Verbindersystem (100) nach einem der Ansprüche 2 bis 7, wobei das kartenseitige Verbinderelement (30) ein kartenseitiges Gehäuse (40) aufweist, welches aus Zinkdruckguss ausgebildet ist.

9. Verbindersystem (100) nach einem der Ansprüche 2 bis 8, wobei die zumindest eine kartenseitige Kontaktelementeinheit (60) im montierten Zustand zwischen dem ersten kartenseitigen Gehäuseelement (40a) und dem zweiten kartenseitigen Gehäuseelement (40b) angeordnet ist.

10. Verbindersystem (100) nach einem der Ansprüche 2 bis 9, wobei das kartenseitige Verbinderelement (30) ferner einen kartenseitigen Isolierkörper (32a) mit einer Mehrzahl von kartenseitigen Isolierhohlräumen (38) aufweist, wobei im montierten Zustand erste Endabschnitte (80a) der kartenseitigen Kontaktelemente (33a) zumindest bereichsweise in den kartenseitigen Isolierhohlräumen (38) angeordnet sind, und wobei die kartenseitigen Isolierhohlräume (38) insbesondere ausgelegt sind, um rechnerseitige Kontaktelemente (13a) des rechnerseitigen Verbinderelements (10) zumindest bereichsweise aufzunehmen.

11. Verbindersystem (100) nach Anspruch 10, wobei der kartenseitige Isolierkörper (32a) im montierten Zustand unmittelbar an die zumindest eine kartenseitige Kontaktelementeinheit (60) angrenzt.

12. Verbindersystem (100) nach einem der Ansprüche 2 bis 11, wobei das kartenseitige Verbinderelement (30) zumindest zwei plattenförmige kartenseitige Kontaktelementeinheiten (60) aufweist und wobei die zumindest zwei plattenförmigen kartenseitigen Kontaktelementeinheiten (60) im montierten Zustand im Wesentlichen parallel zueinander angeordnet sind.

13. Verbindersystem (100) nach einem der Ansprüche 2 bis 12, wobei die kartenseitigen Kontaktelemente (33a) als Single-End Kontaktelemente ausgebildet sind und wobei das kartenseitige Verbinderelement (30) ferner eine Mehrzahl von kartenseitigen Differential-Pair Kontaktelementen (33b) und/oder eine Mehrzahl von Power-Kontaktelementen (33c) aufweist.

14. Verfahren zum Assemblieren eines kartenseitigen Verbinderelements (100), um eine PCB-Karte mit einem Zentralrechner eines Kraftfahrzeugs zu verbinden, umfassend die Schritte:
- Bereitstellen eines ersten kartenseitigen Gehäuseelements (40a) mit einem ersten Fixierelement (53a) und Bereitstellen eines zweiten kartenseitigen Gehäuseelements (40b) mit einem zweiten Fixierelement (53b);
- Bereitstellen von zumindest einer Kontaktelementeinheit (60), wobei jede Kontaktelementeinheit (60) als Hybridbauteil mit einer Mehrzahl von bereichsweise mit einem Isoliermaterial (62) umgebenen Kontaktelementen (33a) ausgebildet ist;
- Anordnen der zumindest einen Kontaktelementeinheit (60) in dem ersten kartenseitigen Gehäuseelement (40a) derart, dass sich erste Endabschnitte (80a) der Kontaktelemente (33a) zumindest bereichsweise in einem Hohlraum des ersten Gehäuseelements (40a) befinden;
- Anordnen des zweiten kartenseitigen Gehäuseelements (40b) an dem ersten kartenseitigen Gehäuseelement (40a) derart, dass zweite Endabschnitte (80c) der Kontaktelemente (33a) aus dem zweiten Gehäuseelement (40b) herausragen, um mit der PCB-Karte verlötet werden zu können; und
- Fixieren des zweiten kartenseitigen Gehäuseelements (40b) mit dem ersten kartenseitigen Gehäuseelement (40a) mit Hilfe des ersten Fixierelements (53a), des zweiten Fixierelements (53b) und eines dritten Fixierelements (53c), indem das dritte Fixierelement (53c) mit dem ersten Fixierelement (53a) und dem zweiten Fixierelement (53b) in Eingriff gebracht wird.

## Claims

1. A board-side connector element (30) for a connector system (100) for connecting a PCB to a central computer of a motor vehicle, comprising:
- at least one board-side contact element unit (60), wherein each contact element unit (60) is designed as a hybrid component comprising a plurality of board-side contact elements (33a) surrounded in regions by an insulating material (62);
- a first board-side housing element (40a) comprising a first securing element (45a);
- a second board-side housing element (40b) comprising a second securing element (45b); and
- a third securing element (45c);
**characterized in that**
the first board-side housing element (40a) can be secured to the second board-side housing element (40b) by means of the first securing element (45a), the second securing element (45b) and the third securing element (45c), which can be brought into engagement with the first securing element (45a) and the second securing element (45b).

2. A connector system (100) for connecting a PCB to a central computer of a motor vehicle, comprising a computer-side connector element (10) and a board-side connector element (30) according to claim 1.

3. The connector system (100) according to claim 2, wherein central portions (80b) of the board-side contact elements (33a) of the at least one board-side contact element unit (60) are surrounded by the insulating material (62) of the hybrid component and wherein first and second end portions (80a, 80c) of the board-side contact elements (33a) of the at least one board-side contact element unit (60) protrude from the insulating material (62) of the hybrid component.

4. The connector system (100) according to any one of claims 2 and 3, wherein the contact elements (33a) of the at least one board-side contact element unit (60) each comprise a substantially right-angled edge (K), and wherein the contact elements (33a) of the at least one board-side contact element unit (60) are arranged inside each of the at least one board-side contact element unit (60) in particular such that the edges (K) substantially lie on a straight line.

5. The connector system (100) according to any one of claims 2 to 4, wherein the computer-side connector element (10) is designed to be connected to the central computer in a first assembly direction (M1), wherein the board-side connector element (30) is designed to be connected to the PCB in a second assembly direction (M2), and wherein the computer-side connector element (10) and the board-side connector element (30) can be plugged together in the first assembly direction (M1).

6. The connector system (100) according to claim 5, wherein first end portions (80a) of the board-side contact elements (33a) of the at least one board-side contact element unit (60) are oriented substantially parallel to the first assembly direction (M1), and wherein second end portions (80c) of the board-side contact elements (33a) of the at least one board-side contact element unit (60) are oriented substantially parallel to the second assembly direction (M2).

7. The connector system (100) according to any one of claims 2 to 6, wherein, in the assembled state, the contact elements (33a) that belong to a board-side contact element unit (60) are arranged in one plane.

8. The connector system (100) according to any one of claims 2 to 7, wherein the board-side connector element (30) comprises a board-side housing (40) that is formed from zinc diecasting.

9. The connector system (100) according to any one of claims 2 to 8, wherein, in the assembled state, the at least one board-side contact element unit (60) is arranged between the first board-side housing element (40a) and the second board-side housing element (40b).

10. The connector system (100) according to any one of claims 2 to 9, wherein the board-side connector element (30) further comprises a board-side insulating body (32a) comprising a plurality of board-side insulating cavities (38), wherein, in the assembled state, first end portions (80a) of the board-side contact elements (33a) are arranged at least in regions in the board-side insulating cavities (38), and wherein the board-side insulating cavities (38) are in particular designed to receive computer-side contact elements (13a) of the computer-side connector element (10) at least in regions.

11. The connector system (100) according to claim 10, wherein, in the assembled state, the board-side insulating body (32a) directly adjoins the at least one board-side contact element unit (60).

12. The connector system (100) according to any one of claims 2 to 11, wherein the board-side connector element (30) comprises at least two planar board-side contact element units (60) and wherein, in the assembled state, the at least two planar board-side contact element units (60) are arranged substantially parallel to one another.

13. The connector system (100) according to any one of claims 2 to 12, wherein the board-side contact elements (33a) are designed as single-end contact elements and wherein the board-side connector element (30) further comprises a plurality of board-side differential pair contact elements (33b) and/or a plurality of power contact elements (33c).

14. A method for assembling a board-side connector element (100) in order to connect a PCB to a central computer of a motor vehicle, comprising the steps of:
- providing a first board-side housing element (40a) comprising a first securing element (53a) and providing a second board-side housing element (40b) comprising a second securing element (53b);
- providing at least one contact element unit (60), wherein each contact element unit (60) is designed as a hybrid component comprising a plurality of contact elements (33a) surrounded in regions by an insulating material (62);
- arranging the at least one contact element unit (60) in the first board-side housing element (40a) such that first end portions (80a) of the contact elements (33a) are located in a cavity of the first housing element (40a) at least in regions;
- arranging the second board-side housing element (40b) on the first board-side housing element (40a) such that second end portions (80c) of the contact elements (33a) protrude from the second housing element (40b) such that they can be soldered to the PCB; and
- securing the second board-side housing element (40b) to the first board-side housing element (40a) by means of the first securing element (53a), the second securing element (53b) and a third securing element (53c) by bringing the third securing element (53c) into engagement with the first securing element (53a) and the second securing element (53b).

## Revendications

1. Élément de raccord côté carte (30) pour un système de raccord (100) destiné à l'assemblage d'une carte à circuit imprimé avec un ordinateur central d'un véhicule automobile, présentant :
- au moins une unité d'élément de contact côté carte (60), chaque unité d'élément de contact (60) étant conçue comme une pièce hybride avec une pluralité d'éléments de contact côté carte (33a) partiellement entourés d'un matériau isolant (62) ;
- un premier élément de boîtier côté carte (40a) avec un premier élément de fixation (45a) ;
- un deuxième élément de boîtier côté carte (40b) avec un deuxième élément de fixation (45b) ; et
- un troisième élément de fixation (45c) ;
**caractérisé en ce que**
- le premier élément de boîtier côté carte (40a) peut être fixé au deuxième élément de boîtier côté carte (40b) à l'aide du premier élément de fixation (45a), du deuxième élément de fixation (45b) et du troisième élément de fixation (45c), lequel peut être mis en prise avec le premier élément de fixation (45a) et le deuxième élément de fixation (45b).

2. Système de raccord (100) destiné à l'assemblage d'une carte à circuit imprimé avec un ordinateur central d'un véhicule automobile, présentant un élément de raccord côté ordinateur (10) et un élément de raccord côté carte (30) selon la revendication 1.

3. Système de raccord (100) selon la revendication 2, dans lequel des sections centrales (80b) des éléments de contact côté carte (33a) de l'au moins une unité d'élément de contact côté carte (60) sont entourées par le matériau isolant (62) de la pièce hybride et dans lequel des première et deuxième sections d'extrémité (80a, 80b) des éléments de contact côté carte (33a) de l'au moins une unité d'élément de contact côté carte (60) font saillie hors du matériau isolant (62) de la pièce hybride.

4. Système de raccord (100) selon l'une des revendications 2 et 3, dans lequel les éléments de contact (33a) de l'au moins une unité d'élément de contact côté carte (60) présentent respectivement une arête (K) substantiellement rectangulaire, et dans lequel les éléments de contact (33a) de l'au moins une unité d'élément de contact côté carte (60) sont disposés de telle façon dans chacune des au moins une unité d'élément de contact côté carte (60), que les arêtes (K) se situent substantiellement sur une droite.

5. Système de raccord (100) selon l'une des revendications 2 à 4, dans lequel l'élément de raccord côté ordinateur (10) est configuré pour être relié à l'ordinateur central le long d'une première direction de montage (M1), dans lequel l'élément de raccord côté carte (30) est configuré pour être relié à la carte à circuit imprimé le long d'une deuxième direction de montage (M2), et dans lequel l'élément de raccord côté ordinateur (10) et l'élément de raccord côté carte (30) peuvent être emboîtés l'un dans l'autre le long de la première direction de montage (M1).

6. Système de raccord (100) selon la revendication 5, dans lequel des premières sections d'extrémité (80a) des éléments de contact côté carte (33a) de l'au moins une unité d'élément de contact côté carte (60) sont orientées substantiellement parallèlement à la première direction de montage (M1), et dans lequel des deuxièmes sections d'extrémité (80c) des éléments de contact côté carte (33a) de l'au moins une unité d'élément de contact côté carte (60) sont orientées substantiellement parallèlement à la deuxième direction de montage (M2).

7. Système de raccord (100) selon l'une des revendications 2 à 6, dans lequel, dans l'état monté, les éléments de contact (33a) appartenant à une unité d'élément de contact côté carte (60) sont disposés dans un plan.

8. Système de raccord (100) selon l'une des revendications 2 à 7, dans lequel l'élément de raccord côté carte (30) présente un boîtier côté carte (40), lequel est conçu en zinc coulé sous pression.

9. Système de raccord (100) selon l'une des revendications 2 à 8, dans lequel l'au moins une unité d'élément de contact côté carte (60) est disposée entre le premier élément de boîtier côté carte (40a) et le deuxième élément de boîtier côté carte (40b) dans l'état monté.

10. Système de raccord (100) selon l'une des revendications 2 à 9, dans lequel l'élément de raccord côté carte (30) présente en outre un corps isolant côté carte (32a) avec une pluralité d'espaces creux isolants côté carte (38), dans lequel, dans l'état monté, des premières sections d'extrémité (80a) des éléments de contact côté carte (33a) sont au moins partiellement disposés dans les espaces creux isolants côté carte (38), et dans lequel les espaces creux isolants côté carte (38) sont en particulier configurés pour recevoir au moins partiellement des éléments de contact côté ordinateur (13a) de l'élément de raccord côté ordinateur (10).

11. Système de raccord (100) selon la revendication 10, dans lequel le corps isolant côté carte (32a) est immédiatement adjacent à l'au moins une unité d'élément de contact côté carte (60) dans l'état monté.

12. Système de raccord (100) selon l'une des revendications 2 à 11, dans lequel l'élément de raccord côté carte (30) présente au moins deux unités d'élément de contact côté carte en forme de plaques (60) et dans lequel les au moins deux unités d'élément de contact côté carte en forme de plaques (60) sont disposées substantiellement parallèlement l'une à l'autre dans l'état monté.

13. Système de raccord (100) selon l'une des revendications 2 à 12, dans lequel les éléments de contact côté carte (33a) sont conçus comme des éléments de contact asymétriques et dans lequel l'élément de raccord côté carte (30) présente en outre une pluralité d'éléments de contact en paires différentielles côté carte (33b) et/ou une pluralité d'éléments de contact d'alimentation (33c).

14. Procédé d'assemblage d'un élément de raccord côté carte (100), permettant de relier une carte à circuit imprimé à un ordinateur central d'un véhicule automobile, comportant les étapes suivantes :
- mise à disposition d'un premier élément de boîtier côté carte (40a) avec un premier élément de fixation (53a) et mise à disposition d'un deuxième élément de boîtier côté carte (40b) avec un deuxième élément de fixation (53b) ;
- mise à disposition d'au moins une unité d'élément de contact (60), chaque unité d'élément de contact (60) étant conçue comme une pièce hybride avec une pluralité d'éléments de contact (33a) partiellement entourés d'un matériau isolant (62) ;
- disposition de l'au moins une unité d'élément de contact (60) dans le premier élément de boîtier côté carte (40a) de telle façon que des premières sections d'extrémité (80a) des éléments de contact (33a) se situent au moins partiellement dans un espace creux du premier élément de boîtier côté carte (40a) ;
- disposition du deuxième élément de boîtier côté carte (40b) sur le premier élément de boîtier côté carte (40a) de telle façon que des deuxièmes sections d'extrémité (80c) des éléments de contact (33a) font saillie hors du deuxième élément de boîtier côté carte (40b), afin de pouvoir être soudés à la carte à circuit imprimé ; et
- fixation du deuxième élément de boîtier côté carte (40b) au premier élément de boîtier côté carte (40a) à l'aide du premier élément de fixation (53a), du deuxième élément de fixation (53b) et d'un troisième élément de fixation (53c), par engagement du troisième élément de fixation (53c) avec le premier élément de fixation (53a) et le deuxième élément de fixation (53b).
